Europäisches Patentamt

European Patent Office

Office européen des brevets

(11) Numéro de publication : **0 422 990 B1**

# (12) FASCICULE DE BREVET EUROPEEN

(45) Date de publication du fascicule du brevet :
**07.12.94 Bulletin 94/49**

(51) Int. Cl.[5] : **H01L 31/052,** H01L 31/101,
H01L 29/14, H01L 29/76

(21) Numéro de dépôt : **90402736.4**

(22) Date de dépôt : **03.10.90**

(54) **Détecteur capacitif d'onde électromagnétique.**

(30) Priorité : **12.10.89 FR 8913326**

(43) Date de publication de la demande :
**17.04.91 Bulletin 91/16**

(45) Mention de la délivrance du brevet :
**07.12.94 Bulletin 94/49**

(84) Etats contractants désignés :
**DE GB**

(56) Documents cités :
**US-A- 4 745 452**
**APPLIED PHYSICS LETTERS vol. 50, no. 25, 22**
**juin 1987, pages 1814-1816, New York, US;**
**K.-K. CHOI et al.: "Multiple quantum well 10**
**micrometers GaAs/A1xGa1-xAs infrared**
**detector with imporved responsivity"**

(73) Titulaire : **THOMSON-CSF**
**173, Boulevard Haussmann**
**F-75008 Paris (FR)**

(72) Inventeur : **Rosencher, Emmanuel**
**THOMSON-CSF**
**SCPI**
**Cédex 67**
**F-92045 Paris la Défense (FR)**
Inventeur : **Vinter, Borge**
**THOMSON-CSF**
**SCPI**
**Cédex 67**
**F-92045 Paris la Défense (FR)**
Inventeur : **Bois, Paul**
**THOMSON-CSF**
**SCPI**
**Cédex 67**
**F-92045 Paris la Défense (FR)**

(74) Mandataire : **Guérin, Michel et al**
**THOMSON-CSF**
**SCPI**
**B.P. 329**
**50, rue Jean-Pierre Timbaud**
**F-92402 Courbevoie Cédex (FR)**

EP 0 422 990 B1

# Description

L'invention concerne un détecteur d'onde électromagnétique et plus particulièrement un détecteur d'onde à semiconducteurs à puits quantiques.

On connaît des dispositifs de détection de rayonnements comportant au moins un puits quantique à composition asymétrique constitué d'un empilement de couches de matériaux de bandes interdites différentes.

C'est ainsi que la demande de brevet français FR-A-2640044 déposée le 6 décembre 1988 décrit une structure destinée à la détection photocapacitive et au traitement de rayonnements optiques. Cette structure est constituée de puits quantiques asymétriques tels que représentés en figure 1a. Lors d'une illumination, les électrons sont excités d'un niveau électronique e1 à un niveau électronique e2, les deux niveaux n'ayant pas le même barycentre. Cette transition induit un dipôle qui peut être détecté aux bornes d'une capacité formée de tels puits quantiques. D'autres effets non linéaires sont associés (doublage de fréquence, effets électro-optiques) qui peuvent être utilisés dans des modulateurs, etc ... De tels effets ont été confirmés expérimentalement (voir Electronics Letters, vol 25, n° 16 du 3 août 89, page 1063 "Second harmonic generation by intersub-band transitions in compositionnally asgmetrical MQWs" de E. ROSENCHER et al).

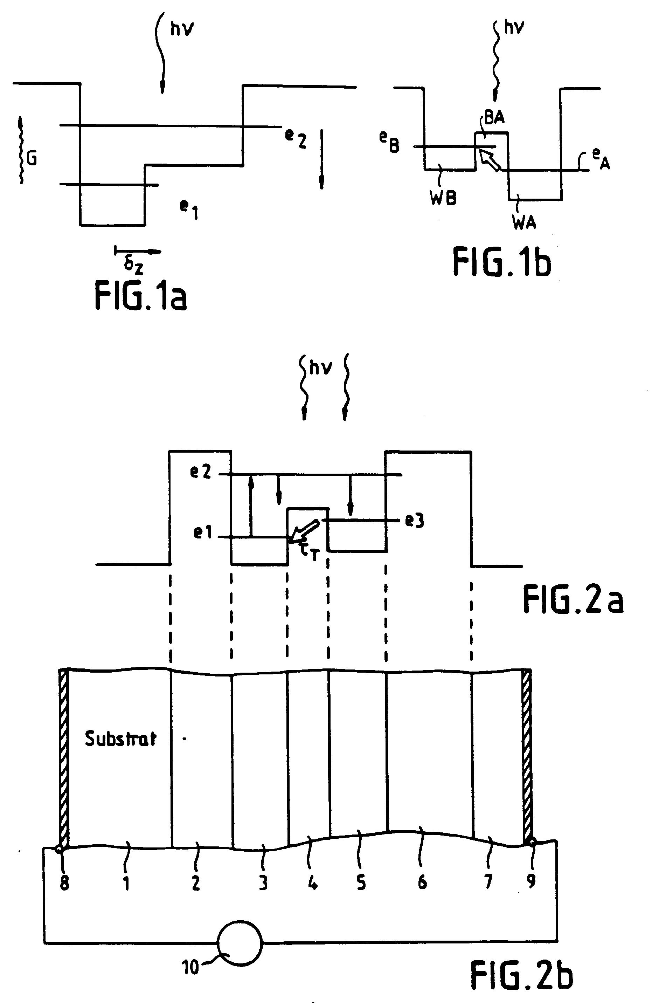

L'invention concerne une structure renforçant tous ces derniers différents effets. Afin de mieux mettre en évidence l'objet de l'invention, revenons sur la structure de la figure 1. Sous éclairement, le taux de génération du niveau électronique e1 au niveau électronique e2 est (figure 1) :

$$G_{12} = B_{12} (n_1 - n_2) \emptyset$$

- $\emptyset$ est le flux de photons,
- $n_1$ et $n_2$ sont les populations sur les niveaux e1 et e2
- $B_{12}$ le coefficient d'émission induite dit coefficient d'EINSTEIN.

La recombinaison est donnée par :

$$R = n_2/\tau$$

où $\tau$ est le temps de relaxation du niveau e2 vers le niveau e1. La polarisation induite par l'illumination est :

$$P = n_2 \, q \int_z$$

soit

$$P = q \int_z \tau_{12} B_{12} (n_1 - n_2) \emptyset$$

où :

- $\int_z$ est le déplacement moyen du gaz électronique
- q est la charge de l'électron

on a donc $= n_2 = \tau B_{12} (n_1 - n_2) \emptyset$

Il est clair qu'en augmentant la durée de vie $\tau$ on augmente le dipôle induit.

On connaît aussi un dispositif présentant un diagramme de la bande de conduction tel que décrit dans le brevet US 4 745 452 représenté par la figure 1b.

Ce dispositif comporte un puits quantique constitué par deux puits quantiques couplés QWA et QWB. Deux niveaux électroniques permis $e_A$ et $e_B$ sont inférieurs une barrière intermédiaire BA. Cependant un fort couplage existe entre les niveaux $e_A$ et $e_B$ en raison notamment de la faible épaisseur de la barrière intermédiaire BA (épaisseur inférieure à 20 nm par exemple). La détection se fait alors par :

- la transition optique $e_A$ vers $e_B$
- et donc par la mesure de la variation de conductance de la structure due aux différences de mobilité d'électrons dans chaque puits.

Un tel dispositif est limité à la détection des ondes électromagnétiques inférieures à quelques TeraHz, soit quelques meV.

L'invention vise un dispositif fonctionnant avec des ondes atteignant 30 à 100 TeraHz soit environ 100 meV.

L'invention concerne un détecteur permettant de résoudre ce problème.

L'invention concerne donc un détecteur capacitif d'onde électromagnétique caractérisé en ce qu'il comprend :

a) une structure semiconductrice possédant au moins un empilement d'une première, deuxième, troisième, quatrième, cinquième, sixième et septième couches dont les largeurs des bandes interdites permettent d'obtenir le profil suivant d'énergie potentielle correspondant au bas de la bande de conduction pour les électrons :

- énergie la plus basse pour la troisième couche ;
- énergies intermédiaires pour les quatrième et cinquième avec une énergie supérieure pour la quatrième couche par rapport à l'énergie de la cinquième couche, la quatrième couche constituant une barrière interne ;
- énergies de valeurs supérieures pour les deuxième et sixième couches constituant les barrières du puits ;

ladite structure est telle que l'énergie correspondant à un premier niveau électronique permis dans la troisième couche étant inférieure à l'énergie potentielle du bas de la bande de conduction du matériau de la quatrième couche, l'énergie correspondant à un deuxième niveau électronique étant comprise entre l'énergie potentielle du bas de la bande de conduction du matériau de la quatrième couche et les énergies potentielles du bas de la bande de conduction des matériaux des deuxième et sixième couches, l'onde électromagnétique à détecter provoquant le transfert d'électrons du premier niveau vers le deuxième niveau electronique, l'énergie correspondant à un troisième niveau électronique dans la cinquième couche étant comprise entre l'énergie potentielle du bas de la bande de conduction du matériau de la quatrième couche et celle de la cinquième couche, ce troisième niveau électronique étant supérieur au premier niveau électronique ;

b) des moyens de peuplement en électrons du premier niveau électronique permis ;

c) des moyens de détection d'un champ électrique connectés aux première et septième couches.

L'énergie potentielle du bas de la bande de conduction du matériau de la quatrième couche et l'épaisseur de cette quatrième couche interdit un couplage électronique fort entre le premier niveau permis $e_1$ et le troisième niveau $e_3$.

L'invention concerne également un dispositif de détection, caractérisé en ce que la différence des niveaux d'énergie des premier et deuxième niveaux correspond sensiblement à l'énergie des photons à détecter.

L'invention concerne un détecteur capacitif d'onde électromagnétique, caractérisé en ce que les largeurs de bandes interdites des deuxième et sixième couches sont sensiblement équivalente.

Selon l'invention, la première couche ou la septième couche au moins est dopée de type n.

La troisième couche est dopée de type $n^+$.

L'invention concerne un détecteur capacitif d'onde électromagnétique, caractérisé en ce qu'il comporte au moins un premier empllement de couches comportant au moins la deuxième, troisième, quatrième, et cinquième couches déposé sur la première couche et, disposé sur le premier empilements, une succession d'empilement de couches comportant chacun des couches identiques au premier empilement puis une sixième couche barrière et une septième couche de contact.

L'invention concerne un détecteur d'onde électromagnétique, caractérisé en ce que les moyens de détection d'un champ électrique comporte des électrodes en contact avec les surfaces extérieures des première et septième couches.

Les différents objets et caractéristiques de l'invention apparaîtront plus clairement dans la description qui va suivre faite à titre d'exemple en se reportant aux figures annexées qui représentent :

- les figures 1a et 1b des diagrammes d'énergies de dispositifs connus dans la technique et décrits précédemment ;
- les figures 2a et 2b, un exemple de réalisation général du dispositif de l'invention ;
- les figures 3 et 4, un exemple de réalisation détaillé de l'invention ;
- la figure 5, un autre exemple de réalisation de l'invention ;
- la figure 6, un exemple d'intégration d'un dispositif selon l'invention avec un transistor à effet de champ ;
- la figure 7, un exemple numérique du dispositif selon l'invention.

L'objet de l'invention concerne un dispositif comportant deux niveaux électroniques liés e1 et e2 et un troisième niveau électronique $e_3$ de grande durée de vie lié au deuxième niveau e2 mais faiblement couplé au premier niveau e1.

En se reportant aux figures 2a et 2b on va décrire un exemple de réalisation d'un tel dispositif. Ce dispositif comporte un empllement de couches 1 à 7 qui va être décrit ci-après notamment en se référant au diagramme d'énergie correspondant à la bande de conduction (figure 2a).

Les différentes couches sont en matériaux tels que la structure de la figure 2b se présente sous la forme d'un puits quantique asymétrique dont les couches 2 et 6 constituent les barrières.

L'énergie potentielle du bas de la bande de conduction de la couche 3 est la plus basse et sert de référence d'énergie dans la description qui va suivre.

L'énergie potentielle du bas de la bande de conduction de la couche 4 est plus élevée que celle de la couche 5 et celle de la couche 3.

L'énergie potentielle du bas de la bande de conduction de la couche 5 est inférieure à celle de la couche 4 et supérieure ou égale à celle de la couche 3.

Les couches 2 et 6 constituant les barrières du puits quantique présentent des bas de bandes de conduction relativement élevés.

La couche 1, qui tient lieu de substrat selon l'exemple de réalisation représenté, et la couche 7, présentent des bas de bande de conduction relativement faibles.

Ces couches 1 et 7 sont fortement dopées de type n.

Cependant dans d'autres formes de réalisation non représentées, une seule couche 1 ou 7 est fortement dopée de type n.

Selon les figures 2a et 2b, la structure active constituée par les couches 2 à 6 est dopée de type n de telle manière que la majorité des électrons soient localisés dans les couches la plus profonde du puits (niveau e1). Par exemple, la couche 3 est dopée de type n.

Les surfaces extérieures des couches 1 et 7 comportent des électrodes 8 et 9 de contact permettant de connecter un dispositif de test de champ électrique, tel que 10, permettant de détecter un champ électrique dans la structure.

La structure des figures 2a et 2b se présente sous la forme d'un puits quantique possédant une barrière interne (couche 4). Elle comporte :

- un premier niveau électronique permis e1 situé entre le bas de la bande de conduction de la couche 3 et le bas de la bande de conduction de la couche 4 ;
- un deuxième niveau électronique e2 compris entre le bas de la bande de conduction de la couche 4 et le bas de la bande de conduction des barrières 2 et 6 ;

- enfin, un troisième niveau électronique e3 compris entre le bas de la bande de conduction de la couche 5 et le bas de la bande de conduction de la couche 4, et supérieur au premier niveau d'énergie e1.

La différence des niveaux d'énergie e1 et e2 correspond à l'énergie photonique h$\nu$ d'un rayonnement à détecter. Ainsi, sous l'effet d'un rayonnement électromagnétique de la fréquence $\nu$, des électrons du niveau e1 vont être excités et vont passer sur le niveau e2. Après un temps de relaxation, ces électrons vont retourner pour une partie sur le niveau e1 et pour une autre partie vont aller peupler le niveau e3.

Le transfert de charges sur le niveau e3 crée un dipôle et donne lieu à un champ électrique détectable aux bornes du dispositif. Les charges du niveau e3 vont ensuite s'écouler par effet tunnel vers le niveau e1 après un temps de relaxation $\tau_T$ (voir figure 2a).

Selon l'exemple de réalisation des figures 2a et 2b, la couche 1 est le substrat. Cependant on pourrait inverser la structure. La couche 7 pourrait alors être le substrat et la couche 1 serait la couche de surface.

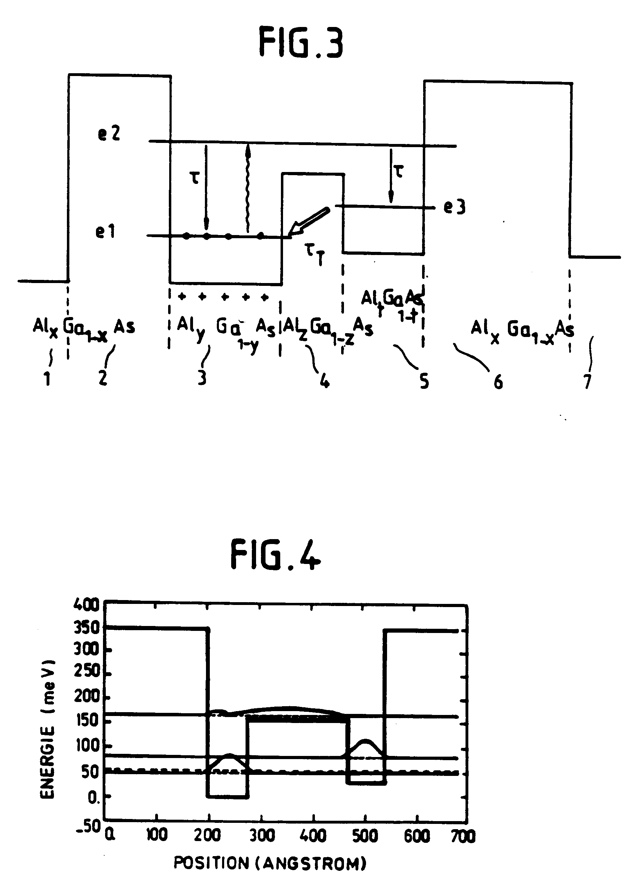

A titre d'exemple la figure 3 représente un exemple de réalisation à base de matériau épitaxiés contraints ou non tel que GaAs/AlGaAs, ou InP/InGaAs.

Par exemple les couches 1 à 7 sont réalisées dans les matériaux suivants :

- couche 1 = GaAs dopé de type n$^+$
- couche 2 = $Al_xGa_{1-x}As$
- couche 3 = $Al_yGa_{1-y}As$ dopé de type n$^+$ au centre
- couche 4 = $Al_zGa_{1-z}As$
- couche 5 = $Al_tGa_{1-t}As$
- couche 6 = $Al_xGa_{1-x}As$
- couche 7 = GaAs dopé de type n$^+$

Dans ces formules, les paramètres x, y, z et t sont tels que :

$$0 \leq y \leq t < z < x$$

L'asymétrie de la structure concernant notamment les couches 3 et 5 peut être contrôlée aussi bien par les paramètres y et t (composition en Al) que par l'épaisseur des couches.

La structure est dopée, notamment la couche 3 de telle sorte que, au repos, la majorité des électrons sont localisés dans le puits le plus profond (niveau e1).

La structure est dopée et la majorité des électrons sont localisés dans le puits le plus profond (niveau e1). Lors de l'irradiation (h$\nu \simeq e_2 - e_1$) les électrons sont excités du niveau e1 au niveau e2 et relaxent soit vers le niveau e1 soit vers le niveau e3 en un temps de l'ordre de 0,2 ps.

Ceux qui sont relaxés sur le niveau e3 vont y rester jusqu'à ce qu'ils transitent par effet tunnel vers le niveau e1.

Ce mécanisme est décrit par les équations suivantes :

$$\frac{\int n_2}{\int t} = G_{12} + G_{32} - n_2(1/\tau_{12} + 1/\tau_{23})$$

$$\frac{\int n_1}{\int t} = -G_{12} + n_2/\tau_{12} + n_3/\tau_T$$

$$\frac{\int n_3}{\int t} = -G_{32} + n_2/\tau_{23} - n_3/\tau_T$$

- n1, n2 et n3 sont les populations d'électrons sur les niveaux e1, e2, e3 respectivement ;
- les taux de génération électronique $G_{12}$ et $G_{32}$ ont été définis précédemment ;
- $\tau_{12}$ est le temps de transit du niveau e1 au niveau e2 ;
- $\tau_{23}$ est le temps de transit du niveau e2 au niveau e3 ;
- $\tau_T$ est le temps de transit par effet tunnel du niveau e3 au niveau e1.

Pour simplifier le calcul, on suppose que les durées de vie $\tau_{12}$ et $\tau_{32}$ sont sensiblement égale ($\simeq \tau$) et que seul le niveau e1 est peuplé :

$$n_2 \ll n_1, n_3 \ll n_1, n_1 \sim N_D$$

($N_D$ = densité surfacique de dopage de la couche 3)

$$G_{12} \sim B N_D \emptyset$$
$$G_{32} \sim B n_3 \emptyset$$

et à l'état stationnaire :

$$n_3 = (B\emptyset/(\emptyset B + 2/\tau_T)) N_D \simeq (B\tau_T/2)N_D \emptyset$$

Si on compare cet état à celui décrit précédemment en relation avec la structure de la figure 1 où on l'a trouvé :

$n_2 \sim B\tau N_D \emptyset$, on trouve que :

le gain en population est donc de l'ordre de $\tau_T/2\tau$

Or, les temps d'effet tunnel peuvent être contrôlés par l'épaisseur de la barrière isolante ou sa composition, ou même par une polarisation appliquée à la structure. Une optimisation doit être réalisée pour augmenter ce temps tunnel sans nuire aux différentes forces d'oscillateur entre les niveaux et en gardant la différence $e_2 - e_1$ de niveaux d'énergies proche de h$\nu$, (l'énergie de l'onde électromagnétique). Les simulations numériques, dont un exemple est représenté en figure 4 prévoient des gains de trois ordres de grandeur sur les différents coefficients non linéaires vis-à-vis de ceux de l'art connu.

L'invention prévoit de réaliser une structure formée de puits quantiques asymétriques couplés tels que décrits précédemment et destinée à présenter des caractéristiques d'optiques non linéaires très importantes, en particulier de rectification optique.

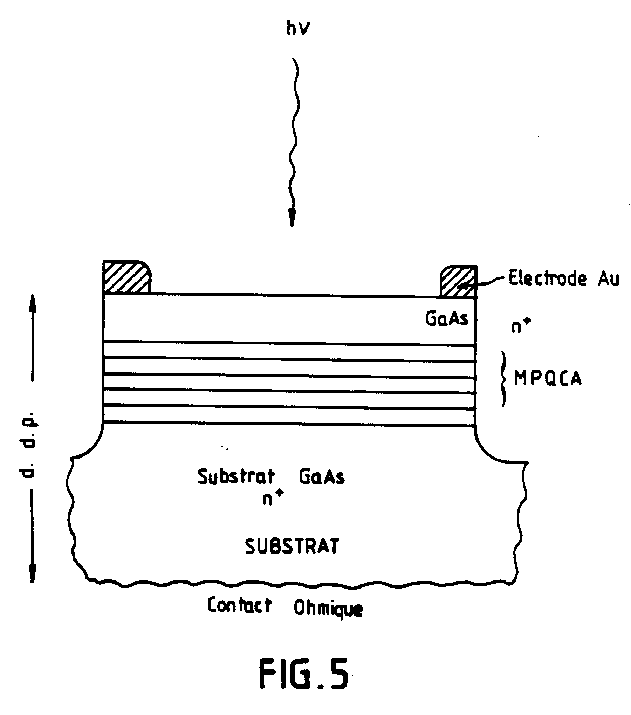

La figure 5 représente une disposition des couches pour réaliser un détecteur de type capacitif. Dans cette structure on réalise un empilement de puits de composition asymétrique tels que décrits précédemment de façon à en réaliser un multipuits quantique de composition asymétrique MPQCA.

Le substrat comporte un contact ohmique. La surface supérieure est recouverte d'une couche de contact (GaAs dopé n$^+$) munie d'électrodes (en or par exemple). Cette surface supérieure est éclairée par un rayonnement hν à détecter.

Les transitions optiques ou les excitations thermiques induisent un dipôle mesurable sous forme d'une différence de potentiel aux bornes de l'échantillon qui est détectable par un détecteur connecté aux électrodes.

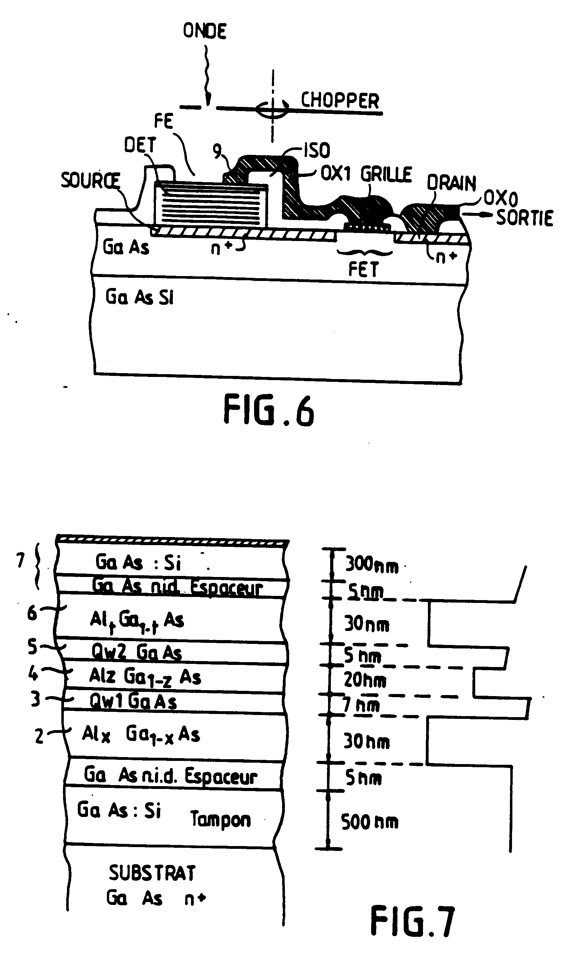

La figure 6, représente l'intégration d'un dispositif selon l'invention avec un transistor tel qu'un transistor à effet de champ. Sur cette figure, on retrouve référencé par DET, le dispositif de l'invention réalisé sous la forme d'un multi-puits quantique.

Le dispositif DET est réalisé sur un substrat en GaAs fortement dopé de type n. Le substrat dopé n$^+$ sert de source au transistor à effet de champ.

La figure 6 représente un tel dispositif intégré dans lequel le dispositif de détection DET, constitué d'un empilement de puits quantiques asymétriques, est intégré à la source d'un transistor à effet de champ.

Selon la figure 6, la structure selon l'invention est réalisée à titre d'exemple en arseniure de gallium et comprend :
- sur un substrat GaAs semi-isolant, une couche de GaAs dopé n et comportant deux zones dopées n$^+$ constituant la source et le drain ;
- une couche métallique constituant la grille du transistor et située entre les deux zones dopées n$^+$ ;
- le dispositif de détection DET constitué d'un empilement de puits quantiques asymétriques et situé sur la zone dopée n$^+$ de la source du transistor ;
- une couche d'isolant ISO permettant d'isoler les flancs du dispositif de détection ainsi que des connexions du transistor ;
- une connexion métallique CX1 permettant de connecter la face supérieure de dispositif DET à la grille du transistor ;
- une connexion métallique CXO connectée au drain du transistor et fournissant un signal de sortie.

La face supérieure du dispositif DET possède une fenêtre FE ne comportant ni isolant ni connexion métallique et permettant à un rayonnement d'agir sur le dispositif DET.

Le rayonnement peut être transmis au dispositif DET par un dispositif de modulation mécanique ou électrooptique tel que cela est représenté sur la figure 6.

Le dispositif DET permet ainsi de créer une différence de potentiel entre la source et la grille. On détecte sur la connexion de drain CXO, un signal de tension de sortie proportionnel à l'intensité de rayonnement fourni au dispositif DET.

La figure 7 représente à titre d'exemple une réalisation chiffrée d'un dispositif selon l'invention. Selon cette invention, le dispositif a été réalisé à base de GaAs sur un substrat de GaAs fortement dopé de type n.

Ce substrat est recouvert d'une couche tampon (BUFFER) de GaAs dopé silicium de 500 nm d'épaisseur puis d'une couche espaceur (SPACER) de GaAs non intentionnellement dopée d'épaisseur 5 nm.

Sur cet ensemble sont réalisées les couches suivantes : couche 2 = en Al$_x$Ga$_{1-x}$As d'épaisseur 30 nm, avec x = 0,42 couche 3 = en GaAs d'épaisseur 7 nm dopé silicium (N$_D$ = 4,3 x 10$^{11}$ cm$^{-2}$)
couche 4 = en Al$_z$Ga$_{1-z}$As d'épaisseur 20 nm, avec z = 0,21
couche 5 = en GaAs non intentionnellement dopé d'épaisseur 5 nm Cet empilement de couches 2 à 5 étant répété 50 fois puis sur l'empilement réalisé on réalise les couches suivantes :
couche 6 = en Al$_x$Ga$_{1-x}$As d'épaisseur 30 nm, avec x = 0,42
couche 7 = constituée d'un espaceur (SPACER) en GaAs non intentionnellement dopé et d'une couche de GaAs dopé silicium d'épaisseurs respectives 5 et 300 nm.

Il est bien évident que la description qui précède a été faite qu'à titre d'exemple non limitatif et que d'autres variantes peuvent être envisagées sans sortir du cadre de l'invention. Les exemples numériques et la nature des matériaux indiqués n'ont été fournis que pour illustrer la description.

**Revendications**

1. Détecteur capacitif d'onde électromagnétique, comprenant :
   a) une structure semiconductrice possédant au moins un empilement d'une première, deuxième, troisième, quatrième, cinquième, sixième et septième couches (1, 2, 3, 4, 5, 6 et 7) dont les largeurs des bandes interdites permettent d'obtenir le profil suivant d'énergie potentielle correspondant au bas de la bande de conduction pour les électrons :
   - énergie (V3) la plus basse pour la troisième couche (3) ;
   - énergie intermédiaires (V4 et V5) pour les quatrième et cinquième couche (4 et 5) avec une énergie supérieure pour la quatrième couche (4) par rapport à l'énergie de la cinquième couche (5), la quatrième couche (4) constituant une barrière interne ;
   - énergies de valeurs supérieures (V2, V6) pour les deuxième et sixième couches (2, 6) constituant les barrières du puits ;
   ladite structure est telle que :

- l'énergie correspondant à un premier niveau électronique permis (e1) dans la troisième couche (3) est inférieure à l'énergie potentielle (V4) du bas de la bande de conduction du matériau de la quatrième couche (4),
- l'énergie correspondant à un deuxième niveau électronique (e2), est comprise entre l'énergie potentielle (V4) du bas de la bande de conduction du matériau de la quatrième couche (4) et les énergies potentielles (V2, V6) du bas de la bande de conduction des matériaux des deuxième et sixième couches (2, 6), l'onde électromagnétique à détecter provoquant le transfert d'électrons du premier niveau électronique (e1) vers le deuxième niveau électronique (e2),
- l'énergie correspondant à un troisième niveau électronique (e3) dans la cinquième couche (5) est comprise entre l'énergie potentielle (V4) du bas de la bande de conduction du matériau de la quatrième couche (4) et l'énergie potentielle (V5) du bas de la bande de conduction du matériau de la cinquième couche (5), ce troisième niveau électronique (e3) étant supérieur au premier niveau électronique (e1), l'énergie potentielle (V4) du bas de la bande de conduction du matériau de la quatrième couche (4) et l'épaisseur (d4) de cette quatrième couche interdit un couplage électronique fort entre le premier niveau permis (e1) et le troisième niveau (e3) ;

b) des moyens de peuplement en électrons du premier niveau électronique permis (e1) ;

c) des moyens de détection d'un champ électrique (8, 9) connectés aux première et septième couches (1, 7).

2. Dispositif de détection selon la revendication 1, caractérisé en ce que la différence des niveaux d'énergie des premier et deuxième niveaux (e1, e2) correspond sensiblement à l'énergie des photons à détecter.

3. Détecteur capacitif d'onde électromagnétique selon la revendication 1, caractérisé en ce que les largeurs de bandes interdites des deuxième et sixième couches (1, 6) sont sensiblement équivalentes.

4. Détecteur capacitif d'onde électromagnétique selon la revendication 1, caractérisé en ce que les largeurs de bandes interdites des première et septième couches (1, 7) sont sensiblement équivalentes.

5. Détecteur d'onde électromagnétique selon la revendication 1, caractérisé en ce que la première ou la septième couche (1 ou 7) au moins est dopée de type n.

6. Détecteur capacitif d'onde électromagnétique selon la revendication 1, caractérisé en ce que la troisième couche (3) est dopée de type $n^+$.

7. Détecteur capacitif d'onde électromagnétique selon la revendication 1, caractérisé en ce qu'il comporte au moins un premier empilement de couches (PQ1) comportant au moins la deuxième, troisième, quatrième, cinquième couches (2 à 5) disposé sur la première couche et, disposé sur le premier empilement, une succession d'empilements de couches (PQ2 à PQn) comportant chacun des couches identiques au premier type d'empilement (PQ1) puis une sixième couche barrière (6) et une septième couche de contact (7).

8. Détecteur d'onde électromagnétique selon la revendication 1, caractérisé en ce que les moyens de détection d'un champ électrique comporte des électrodes (8, 9) en contact avec les surfaces extérieures des première et septième couches (1, 7).

9. Dispositif de détection caractérisé en ce qu'il comporte un transistor à effet de champ et qu'un empilement de plusieurs puits quantiques selon la revendication 7, est intégré au drain ou à la grille du transistor à effet de champ de façon à ce qu'une tension créée entre les deux couches extrêmes de l'empilement de puits quantiques permet de commander le transistor à effet de champ.

**Patentansprüche**

1. Kapazitiver Detektor für elektromagnetische Wellen, der folgendes aufweist:

a) eine Halbleiterstruktur, die wenigstens eine Übereinanderlagerung einer ersten, zweiten, dritten, vierten, fünften, sechsten und siebten Schicht (1, 2, 3, 4, 5, 6 und 7) aufweist, bei denen es die Breiten der verbotenen Bänder ermöglichen, das folgende Profil der potentiellen Energie zu erhalten, die dem unteren Teil des Leitungsbandes für die Elektronen entspricht:

- die niedrigste Energie (V3) für die dritte Schicht (3);
- Zwischenenergien (V4 und V5) für die vierte und fünfte Schicht (4 und 5) mit einer höheren Energie für die vierte Schicht (4) bezüglich der Energie der fünften Schicht (5), wobei die vierte Schicht (4) eine interne Barriere bildet;

- Energien mit höheren Werten (V2, V6) für die zweite und sechste Schicht (2, 6), die die Potentialbarrieren bilden; wobei die Struktur derart ist, daß:

- die einem ersten erlaubten Elektronenniveau (e1) in der dritten Schicht (3) entsprechende Energie unter der potentiellen Energie (V4) des unteren Teils des Leitungsbandes des Materials der vierten Schicht (4) liegt,

- die einem zweiten Elektronenniveau (e2) entsprechende Energie zwischen der potentiellen Energie (V4) des unteren Teils des Leitungsbandes des Materials der vierten Schicht (4) und den potentiellen Energien (V2, V6) des unteren Teils des Leitungsbandes der Materialien der zweiten und sechsten Schicht (2, 6) liegt, wobei die zu erfassende elektromagnetische Welle die Übertragung von Elektronen des ersten Elektronenniveaus (el) zu dem zweiten Elektronenniveau (e2) hervorruft,

- die einem dritten Elektronenniveau (3) in der fünften Schicht (5) entsprechende Energie zwischen der potentiellen Energie (V4) des unteren Teils des Leitungsbandes des Materials der vierten Schicht (4) und der potentiellen Energie (V5) des unteren Teils des Leitungsbandes des Materials der fünften Schicht (5) liegt, wobei, da dieses dritte Elektronenniveau (e3) über dem ersten Elektronenniveau (e1) liegt, die potentielle Energie (V4) des unteren Teils des Leitungsbandes des Materials der vierten Schicht (4) und die Dicke (d4) dieser vierten Schicht eine starke elektronische Kopplung zwischen dem ersten erlaubten Niveau (e1) und dem dritten Niveau (e3) verbietet;

b) Mittel zur Elektronenbesetzung des ersten erlaubten Elektronenniveaus (e1);

c) Mittel zum Erfassen eines elektrischen Feldes (8, 9), die an die erste und siebte Schicht (1, 7) angeschlossen sind.

2. Detektionsvorrichtung nach Anspruch 1, dadurch gekennzeichnet, daß die Differenz zwischen den Energieniveaus des ersten und zweiten Niveaus (e1, e2) im wesentlichen der Energie der zu erfassenden Photonen entspricht.

3. Kapazitiver Detektor für elektromagnetische Wellen nach Anspruch 1, dadurch gekennzeichnet, daß die Breiten der verbotenen Bänder der zweiten und sechsten Schicht (1, 6) im wesentlichen äquivalent sind.

4. Kapazitiver Detektor für elektromagnetische Wellen nach Anspruch 1, dadurch gekennzeichnet, daß die Breiten von verbotenen Bändern der ersten und siebten Schicht (1, 7) im wesentlichen äquivalent sind.

5. Detektor für elektromagnetische Wellen nach Anspruch 1, dadurch gekennzeichnet, daß wenigstens die erste oder die siebte Schicht (1 oder 7) n-dotiert ist.

6. Kapazitiver Detektor für elektromagnetische Wellen nach Anspruch 1, dadurch gekennzeichnet, daß die dritte Schicht (3) $n^+$-dotiert ist.

7. Kapazitiver Detektor für elektromagnetische Wellen nach Anspruch 1, dadurch gekennzeichnet, daß er wenigstens eine erste, auf der ersten Schicht angeordnete Übereinanderlagerung (PQ1) von Schichten mit wenigstens der zweiten, dritten, vierten und fünften Schicht (2 bis 5) sowie eine auf der ersten Übereinanderlagerung angeordnete Folge von Übereinanderlagerungen (PQ2 bis PQn) aus Schichten, die jeweils Schichten umfassen, die mit dem ersten Typ der Übereinanderlagerung (PQ1) identisch sind, sowie dann eine sechste Barrierenschicht (6) und eine siebte Kontaktschicht (7) aufweist.

8. Detektor für elektromagnetische Wellen nach Anspruch 1, dadurch gekennzeichnet, daß die Mittel zum Erfassen eines elektrischen Feldes Elektroden (8, 9) umfassen, die mit den Außenflächen der ersten und siebten Schicht (1, 7) in Kontakt stehen.

9. Detektionsvorrichtung, dadurch gekennzeichnet, daß sie einen Feldeffekttransistor aufweist, und daß eine Übereinanderlagerung aus mehreren Quantentöpfen nach Anspruch 7 mit dem Drain- oder Gate-Anschluß des Feldeffekttransistors integriert ist, so daß eine zwischen den beiden äußersten Schichten der Übereinanderlagerung von Quantentöpfen erzeugte Spannung die Steuerung des Feldeffekttransistors ermöglicht.

**Claims**

1. Capacitive electromagnetic wave detector comprising:

a) a semiconductor structure possessing at least one stack of a first, second, third, fourth, fifth, sixth and seventh layers (1, 2, 3, 4, 5, 6 and 7), in which the widths of the forbidden bands make it possible to obtain the following profile of potential energy corresponding to the bottom of the conduction band for the electrons:

- the lowest energy (V3) for the third layer (3);
- intermediate energies (V4 and V5) for the fourth and fifth layer (4 and 5) with a higher energy for the fourth layer (4) with respect to the energy of the fifth layer (5), the fourth layer (4) constituting an internal barrier;
- higher-value energies (V2, V6) for the second and sixth layers (2, 6) constituting the barriers of the well;
  the said structure is such that:
- the energy corresponding to a first permitted electron level (e1) in the third layer (3) is lower than the potential energy (V4) of the bottom of the conduction band of the material of the fourth layer (4),
- the energy corresponding to a second electron level (e2) lies between the potential energy (V4) of the bottom of the conduction band of the material of the fourth layer (4) and the potential energies (V2, V6) of the bottom of the conduction band of the materials of the second and sixth layers (2, 6), the electromagnetic wave to be detected causing the transfer of electrons from the first electron level (e1) to the second electron level (e2),
- the energy corresponding to a third electron level (e3) in the fifth layer (5) lies between the potential energy (V4) of the bottom of the conduction band of the material of the fourth layer (4) and the potential energy (V5) of the bottom of the conduction band of the material of the fifth layer (5), this third electron level (e3) being higher than the first electron level (e1), the potential energy (V4) of the bottom of the conduction band of the material of the fourth layer (4) and the thickness (d4) of this fourth layer prohibits strong electron coupling between the first permitted level (e1) and the third level (e3);

b) means for populating the first permitted electron level (e1) with electrons;

c) means for detecting an electric field (8, 9) connected to the first and seventh layers (1, 7).

2. Detection device according to Claim 1, characterized in that the difference in the energy levels of the first and second levels (e1, e2) corresponds substantially to the energy of the photons to be detected.

3. Capacitive electromagnetic wave detector according to Claim 1, characterized in that the widths of forbidden bands of the second and sixth layers (1, 6) are substantially equivalent.

4. Capacitive electromagnetic wave detector according to Claim 1, characterized in that the widths of forbidden bands of the first and seventh layers (1, 7) are substantially equivalent.

5. Electromagnetic wave detector according to Claim 1, characterized in that at least the first or the seventh layer (1 or 7) is type n doped.

6. Capacitive electromagnetic wave detector according to Claim 1, characterized in that the third layer (3) is type n+ doped.

7. Capacitive electromagnetic wave detector according to Claim 1, characterized in that it includes at least one first stack of layers (PQ1) including at least the second, third, fourth, fifth layers (2 to 5) arranged on the first layer and, arranged on the first stack, a succession of stacks of layers (PQ2 to PQn) each including layers identical to the first type of stack (PQ1) then a sixth barrier layer (6) and a seventh contact layer (7).

8. Electromagnetic wave detector according to Claim 1, characterized in that the means of detecting an electric field include electrodes (8, 9) in contact with the outer surfaces of the first and seventh layers (1, 7).

9. Detection device characterized in that it includes a field-effect transistor and that a stack of several quantum wells according to Claim 7 is integrated into the drain or into the gate of the field-effect transistor in such a way that a voltage created between the two extreme layers of the stack of quantum wells makes it possible to control the field-effect transistor.

hν

G

e₂

e₁

$\delta_z$

FIG.1a

hν

BA

eB

eA

WB

WA

FIG.1b

hν

e2

e1

e3

T

FIG.2a

Substrat

8   1   2   3   4   5   6   7   9

10

FIG.2b

# FIG.3

# FIG.4

FIG.5

ONDE
CHOPPER
FE
DET
SOURCE
9
ISO
OX1 GRILLE DRAIN
OX0
SORTIE
Ga As
n+
n+
FET
Ga As SI

**FIG.6**

| | | |
|---|---|---|
| 7 { | Ga As : Si | 300 nm |
| | Ga As n.i.d. Espaceur | 5 nm |
| 6 | Al_f Ga_{1-f} As | 30 nm |
| 5 | Qw2 Ga As | 5 nm |
| 4 | Alz Ga_{1-z} As | 20 nm |
| 3 | Qw1 Ga As | 7 nm |
| 2 | Al x Ga_{1-x} As | 30 nm |
| | Ga As n.i.d. Espaceur | 5 nm |
| | Ga As : Si  Tampon | 500 nm |
| | SUBSTRAT Ga As n+ | |

**FIG.7**